# EUROPEAN PATENT APPLICATION

(11) **EP 3 883 192 A1**
(43) Date of publication of application: **22.09.2021**
(21) Application number: 20164588.4
(22) Date of filing: 20.03.2020
(51) Int. Cl.: H04L 12/28, H04N 7/173, H04N 21/61

(54) **CABLE MODEM AND CONTROL APPARATUS FOR A CABLE MODEM**

(71) Applicant: INTEL Corporation, Santa Clara, CA 95054 (US)
(72) Inventor: SHULMAN, Shaul, Ramat Gan (IL); HERMESH, Barak, M 37000 Pardes Hana (IL); GOICHBERG, Nathan, 7749619 Ashod (IL)
(74) Representative: 2SPL Patentanwälte PartG mbB

(57) **Abstract**

Examples relate to a control apparatus, control device and control method for a cable modem, and to a cable modem. The control apparatus or control device comprises interface circuitry or communication means (312) for communicating with one or more other components of the cable modem, and processing circuitry or processing means (314) that is configured to obtain information on a temperature of a power amplifier or power amplification means (320) of the cable modem from temperature measurement circuitry or temperature measurement means (330) of the cable modem, and to control a duty cycle of the power amplifier based on the information on the temperature.

## Description

### Field

Examples relate to a control apparatus, control device and control method for a cable modem, and to a cable modem.

### Background

One of the components used in cable modems, such as DOCSIS (Data Over Cable Service Interface Specification) cable modems, is a power amplifier that is used in the transmitter circuitry of the cable modem. When designing the DOCSIS power amplifier and its heat dissipation solutions, the corner conditions for its use are generally taken into account. One such critical parameter is the maximal time of continuous transmission at full output power. In general, a conservative assumption may be made that the amplifier must be able to transmit indefinitely with 100% duty cycle. While such a use case is not often, if ever, observed in actual deployments, there might not be a way to guarantee that the amplifier would not be used at 100% duty cycle, so the Gateway platform design is usually designed with this restrictive assumption. This may create a situation of overdesign (and thus higher component cost for heat sinks, packaging and more capable amplifiers) without an actual use case.

### Brief description of the Figures

Some examples of apparatuses and/or methods will be described in the following by way of example only, and with reference to the accompanying figures, in which
- Fig. 1: shows a schematic illustration of a temperature of a power amplifier over a transmission time;
- Fig. 2: shows a schematic illustration of an on-state of a power amplifier over a transmission time;
- Figs. 3a to 3c: show block diagrams of examples of a control apparatus or control device for a cable modem, and of a cable modem;
- Fig. 4: shows a flow chart of an example of a method for a cable modem;
- Fig. 5: shows a schematic diagram of system components of a DOCSIS gateway/cable modem;
- Fig. 6: shows a schematic illustration of transmission throttling being performed according to an example; and
- Fig. 7: shows a schematic illustration of a temperature control algorithm.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

"Class A" Highly linear amplifiers which are used in DOCSIS upstream Gateways (i.e. upstream components of a cable modem) are generally less efficient and consume power with little to no dependence on the actual transmitted signal. As soon as such an amplifier is switched to an operating state, it may start generating heat that is dissipated into the PCB (Printed Circuit Board) and the surrounding air. The heat generated by the amplifier is added to the heat generated by the other devices in the system and is to be dissipated to keep the amplifier itself, the surrounding integrated circuits and the entire system within allowed operating range. Large heat sinks are often used to dissipate the heat from amplifiers.

If the transmission is constant over time, the system (i.e. the cable modem) eventually reaches a constant temperature, resulting from the heat of the amplifier and the other components, the ambient temperature and the systems heat dissipation rate. Once the amplifier is switched to an "off state it stops generating heat and the system returns over time to a different temperature without the amplifier's heat contribution.

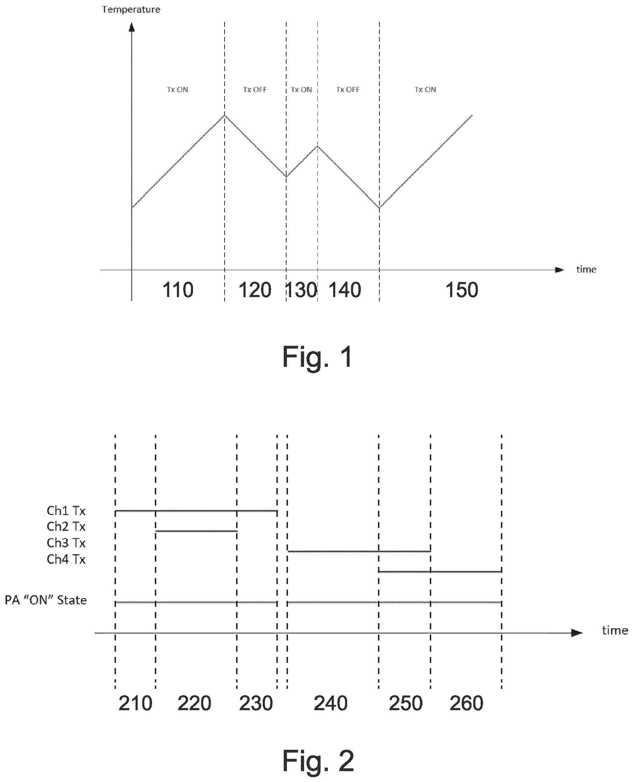

Fig. 1 shows a schematic illustration of a temperature of a power amplifier over a transmission time, e.g. a simplified example of the amplifier temperature vs. transmission time. In Fig. 1, five subsequent operating states 110-150 are shown over time (x-axis): A first 110 operating state, where the power amplifier of the transmitter is turned on ("TX on"), which leads to a rise in temperature of the power amplifier (y-axis), a second 120, where the power amplifier of the transmitter is turned off ("TX off'), which leads to a decrease in the temperature of the power amplifier, a third 130, where the power amplifier of the transmitter is turned on again, which leads to another rise in temperature of the power amplifier, a fourth 140, where the power amplifier of the transmitter is turned off again, which leads to a corresponding decrease in the temperature of the power amplifier, and a fifth 150 where the power amplifier of the transmitter is turned on again, which leads to another rise in temperature of the power amplifier.

The example shown in Fig. 1 is simplified - in reality the temperature curves might not be linear, and their shape depends on the ambient temperatures in addition to the heat of the amplifier on itself.

Some DOCSIS signal CM (Cable Modem) transmitter specifications may require the use of highly linear PGAs (Programmable Gain Amplifier) to comply with the transmit MER (Modulation Error Ratio) and emissions requirements. The CM may transmit OFDMA (Orthogonal Frequency Division Multiple Access) and TDMA (Time Division Multiple Access) single carrier QAM (Quadrature Amplitude Modulation) channels in transmission bursts scheduled by the network. The schedule and frequency of transmitting bursts might not be known in advance as it is dependent on the scheduling and on the amount of data that the CM has to transmit. Theoretically, there may be a scenario in which the CM has a large amount of data to send, keeps requesting transmission grants and in network conditions that are not busy gets grants over several channels that over time result in a nearly constant transmit state. The following figure shows a graphical representation of such a scenario, with the PA being in the "ON" state whenever one of the channels is bursting.

Fig. 2 shows a schematic illustration of an on-state of a power amplifier over a transmission time. In Fig. 2, transmissions in four transmission channels (Ch1 Tx - Ch4 Tx) are shown, together with a corresponding state of the PA (PA "ON" state). The transmission time can be sub-divided into intervals. In a first time interval 210, transmissions are performed on channel 1, in a second time interval 220, transmissions are performed on channels 1 and 2, and in a third time interval 230, transmissions are performed on channel 1. During the three time intervals 210-230, the PA continuously remains in an on-state. After, the third time interval, the PA is shortly switched off, until is switched on again with the beginning of a fourth time interval 240, where transmissions are performed on channel 3. The fourth time interval is succeeded by a fifth time interval 250, where transmissions are performed on channels 3 and 4, which is followed by a sixth time interval 260, where transmissions are performed on channel 4. During the fourth to sixth time intervals 240-260, the PA continuously remains in an on-state.

Such a transmission pattern may result in high heat generation and amplifier's junction temperature and the overall system temperature levels may be high, making the thermal design more challenging. Dissipating more heat may mean larger heat sinks, larger heat dissipating area, fans etc. adding to complexity and cost. Thermal considerations may also impact the form factor of customers products and limit its design.

In reality such use cases are uncommon in actual deployments. Supporting such use case may result in over-design.

Various examples of the present disclosure may thus provide a Layer 2 Assisted DOCSIS Power Amplifier temperature and power consumption control.

In examples, the temperature of the PA may be sensed, and the temperature may be controlled by reducing the effective duty cycle of the transmission, e.g. by first throttling cable modem bandwidth requests and then, if needed, disabling transmission altogether until the temperature drops back to normal. Examples may thus provide a thermometer on (or in) the PA. Examples may alter an upstream request pattern when data is provided at a rate that may cause a 100% transmission duty cycle.

Such a scheme may enable cost reductions due to less over-design, by assuming more realistic use cases and scenarios instead of worst-case scenarios, thus reducing the requirements for the thermal design of the amplifier and PCB. Furthermore, a form factor reduction may be enables as a trade-off of upstream rate and heat dissipation ability. Smaller form factors may be capable to dissipate less heat. Examples may allow a limitation of the upstream data rate, thus maintaining the temperature within the required limits. Examples may allow reducing the peak sustained power consumption of the power amplifier and may allow avoiding using a heat sink or costlier package for power dissipation.

In the following, an apparatus, device, method and cable modem is shown that may provide such functionality.

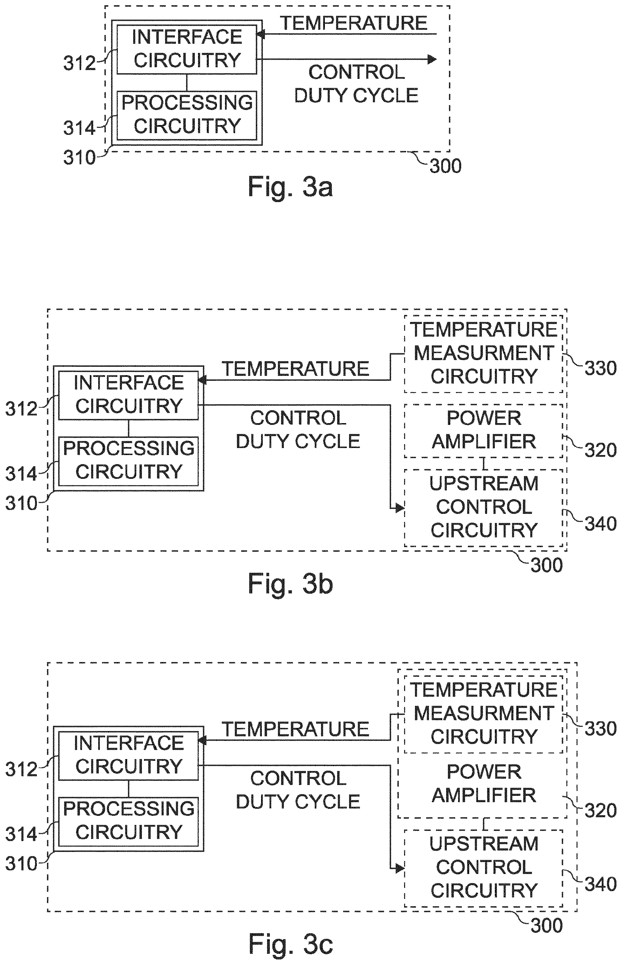

Figs. 3a to 3c show block diagrams of examples of a control apparatus 310 or control device 310 for a cable modem 300 and of a corresponding cable modem 300. The components of the control device 310 are defined as component means, which correspond to the respective structural components of the control apparatus 310. The control apparatus / device comprises interface circuitry 312 / communication means 312 for communicating with one or more other components of the cable modem. The control apparatus device further comprises processing circuitry 314 / processing means 314, which is coupled to the interface circuitry 312 / communication means 312. In the following, where the functionality of the control apparatus 310, and of the corresponding processing circuitry 314 and interface circuitry 312 is introduced, the same functionality also applies to the corresponding control device, processing means and communication means. The processing circuitry is configured to obtain information on a temperature of a power amplifier 320 (i.e. of a power amplification means 320) of the cable modem from temperature measurement circuitry 330 (i.e. of a temperature measurement means 330) of the cable modem. The processing circuitry is configured to control a duty cycle of the power amplifier based on the information on the temperature.

Figs. 3a to 3c further show examples of the cable modem 300. In general, as shown in Figs. 3b and 3c, the cable modem 300 comprises a power amplifier 320 (i.e. power amplification means 320) for amplifying a transmission signal of the cable modem, e.g. of a transmission signal of transmitter circuitry of the cable modem. The cable modem 300 comprises temperature measurement circuitry 330 (i.e. temperature measurement means 330) for determining information on a temperature of the power amplifier. Additionally, as shown in Fig. 3a to 3c, the cable modem may comprise the control apparatus / device 310. In some examples, however, another component may take over the functionality of the control apparatus / device 310, such that the control apparatus / device may be seen as optional.

Examples of the present disclosure relate to a cable modem and to a corresponding control apparatus, control device, control method and/or computer program for a cable modem. In general, a cable modem is a modulator/demodulator (or, in short, "modem") for accessing a cable communication network. In this context, the term "cable" may refer to coaxial cable, and the cable communication network may correspondingly be a communication network wherein the modems are connected to a central instance (e.g. a cable modem termination system) via coaxial cable, at least at the last mile. For example, the cable modem may be a cable modem for communicating based on the Data Over Cable Service Interface Specification, DOCSIS. Accordingly, the cable communication network may be a DOCSIS-based cable communication network. In the context of the present disclosure, the cable modem is also denoted a gateway, e.g. a DOCSIS gateway, as it may provide a gateway to a DOCSIS-based cable communication network. There are various versions and implementations of the DOCSIS, examples, however, may be applicable to any current, past or future version of the DOCSIS.

In general, cable communication networks use a shared spectrum, i.e. both the uplink spectrum and the downlink spectrum is shared among a plurality of cable modems. While transmission in the downlink spectrum are transmitted by a single entity, e.g. the DOCSIS Cable Modem Termination System, CMTS (and thus require no additional scheduling), transmissions of the cable modems within the uplink spectrum are scheduled by the scheduler of the cable communication network. The cable modems are assigned so-called slots or mini-slots (i.e. time slots) in the upstream channels of the upstream spectrum, and the cable modems use these slots to transmit their upstream packets on the shared medium. In many cases, the upstream spectrum comprises multiple channels (e.g. as shown in Fig. 2), such that a cable modem transmit in more than one channel at once. On the other hand, due to the transmissions of other cable modems, and/or due to the lack of data to transmit, only a (small) portion of the time, data is usually transmitted by a cable modem. (Only) during this time, the power amplifier of the cable modem (i.e. the power amplifier of a transmitter circuitry/transmission means of the cable modem) might be on, else it may be powered off. Also, only if the power amplifier is in an on-state, heat may be generated by the power amplifier, and the temperature of the power amplifier may rise. There are also other factors that influence the temperature of the power amplifier, such as the ambient temperature, the heat generated by other components of the cable modem, heat dissipation by cooling systems of the cable modem etc., but the activation or deactivation of the power amplifier may have the biggest influence on its temperature.

The cable modem comprises the power amplifier (i.e. the power amplifier of the transmission circuitry of the cable modem) and the temperature measurement circuitry. For example, the power amplifier may be an amplifier of the cable modem that is configured to amplify upstream transmissions of the cable modem for transmission in the shared spectrum of the cable communication system. In general, the temperature measurement circuitry is used to determine the information on the temperature of the power amplifier. Thus, the temperature measurement circuitry may be arranged in close proximity of the power amplifier. For example, the temperature measurement circuitry may be integrated in the power amplifier. For example, the temperature measurement circuitry may be circuitry that is integrated in the circuitry of the power amplifier. For example, temperature measurement circuitry may be employed that determines the information on the temperature base based on a resistance of an electrical connection between two measurement nodes. Other implementations are possible as well. Alternatively, the temperature measurement circuitry may be separate from the power amplifier. For example, a measurement probe of the temperature measurement circuitry may be affixed to the power amplifier, or to a component that is arranged adjacent to the power amplifier (as long as the measured temperature is indicative of the temperature of the power amplifier). In some examples, multiple measurement probes may be used, and e.g. placed on different sides of the power amplifier.

The temperature measurement circuitry is configured to provide the information on the temperature of the power amplifier. For example, the information on the temperature of the power amplifier may be implemented using different approaches. It is, however, characterized by its information content, which is indicative of the temperature of the power amplifier. For example, the information on the temperature may be an analog or digital signal that is indicative of the temperature of the power signal, e.g. a current or voltage that is indicative of the temperature, or a sequence of pulses that is indicative of the temperature. Alternatively, the information on the temperature may be a numeric value or a bit vector (e.g. in temperature coding) that is indicative of the temperature of the power amplifier. For example, the temperature of the power amplifier may be presented in degrees, e.g. degrees centigrade or Fahrenheit, or as one of multiple ranges (e.g. low, high, very high).

The information on the temperature of the power amplifier is processed by the control apparatus, e.g. by the processing circuitry of the control apparatus. The processing circuitry is configured to obtain (e.g. receive, read out or sense) the information on the temperature of the power amplifier 320 of the cable modem from the temperature measurement circuitry 330 of the cable modem, e.g. via the interface circuitry 312.

The processing circuitry uses the information on the temperature of the power amplifier to control the duty cycle of the power amplifier. For example, the duty cycle of the power amplifier may relate to the time occupied by the on-state of the power amplifier, e.g. as percentage of time. In general, the processing circuitry is configured to control the duty cycle of the power amplifier based on the information on the temperature. In many examples, the controlling of the duty cycle is performed indirectly, e.g. by instructing upstream control circuitry of the cable modem to adjust the duty cycle of the power amplifier. In other words, the processing circuitry may be configured to control the duty cycle by providing a control signal to an upstream control circuitry 340 (i.e. an upstream controller) of the cable modem (shown in Figs. 3b and 3c), in order to trigger the upstream control circuitry to adjust the duty cycle of the power amplifier. In other words, the duty cycle of the power amplifier may be adjusted by or via the upstream control circuitry 340. In some examples, even the upstream control circuitry may adjust the duty cycle of the power amplifier indirectly, as will become evident in the following.

In general, there are two approaches for adjusting the duty cycle of the power amplifier - by requesting (and subsequently receiving) fewer grants for upstream transmissions, or by skipping upstream transmissions that have been granted. For example, the processing circuitry may be configured to control the duty cycle of the power amplifier by adjusting a rate of requests for upstream transmission grants of the cable modem. In other words, transmission grants may be requested at a different, e.g. at a lower rate. In general, the transmission grants may be requested by the upstream control circuitry, so the processing circuitry may be configured to provide the control signal to the upstream control circuitry such, that the upstream control circuitry is triggered to request transmission grants at a different / lower rate, based on the information on the temperature of the power amplifier. For example, the processing circuitry may be configured to lower the duty cycle of the power amplifier by lowering the rate of requests for upstream transmission grants of the cable modem, e.g. by providing the control signal to the upstream control circuitry such, that the upstream control circuitry is triggered to request transmission grants at a lower rate. An any case, the rate of requests may be adjusted based on the temperature of the power amplifier, e.g. according to a pre-defined transformation function. For example, the rate of requests may be adjusted such, that the rate of requests shows a negative correlation with the temperature of the power amplifier. In other words - the hotter the power amplifier, the lower the rate of requests may be chosen. As the rate of requests is negotiated over the communication network, i.e. layer 2 of the communication network, this approach may be denoted a layer 2-assisted approach.

One way of adjusting the rate of requests is a parameter that can be set by the cable modem that influences the grants that a cable modem receives from the CMTS: The Maximum Sustained Rate (MSR). The maximum sustained rate (or Maximum Sustained traffic Rate) is a rate that defines how many sustained upstream transmission grants are provided for a cable modem. In general, the MSR of a cable modem is set by the CMTS. Exceptionally, however, the MSR can be adjusted the CM. In various examples, the MSR may be adjusted to adjust the rate of requests, e.g. to lower the rate of requests. In other words, the processing circuitry may be configured to adjust the rate of the requests for upstream transmission grants by adjusting a maximum sustained rate for transmissions of the cable modem. For example, the processing may be configured to provide the control signal such, that the upstream control circuitry is triggered to adjust the maximum sustained rate (MSR) for transmissions of the cable modem. For example, to lower the rate of requests, the MSR may be lowered.

Another, more drastic approach to adjusting (or specifically lowering) the duty cycle of the power amplifier lies in foregoing (i.e. skipping) transmission slots that have been granted to the cable modem. By foregoing these transmission slots, additional delay may be introduced, and additional grants may be requested, resulting in an increased overhead. On the other hand, such an artificial pause may enable the power amplifier to cool down, resulting in an overall reliable operation of the cable modem. Accordingly, the processing circuitry may be configured to control the duty cycle of the power amplifier by skipping one or more upstream transmissions. As these transmissions are coordinated by the upstream control circuitry, the circuitry may be instructed to do so by the control apparatus. In other words, the processing circuitry may be configured to provide the control signal to the upstream control circuitry such, that the upstream control circuitry is triggered to control the duty cycle of the power amplifier by skipping one or more upstream transmissions. In particular, the processing circuitry may be configured to lower the duty cycle by skipping one or more upstream transmissions, e.g. by providing the control signal to the upstream control circuitry such, that the upstream control circuitry is triggered to lower the duty cycle of the power amplifier by skipping one or more upstream transmissions.

In general, the above approaches may be used if the temperature of the power amplifier reaches a threshold - e.g. if the temperature is at or close to dangerous levels. In other words, the processing circuitry may be configured to lower the duty cycle of the power amplifier if the information on the temperature indicates that the temperature of the power amplifier is above a temperature threshold. Below the temperature threshold, a default duty cycle of the power amplifier may be retained. Above the temperature threshold, a further distinction may be made.

For example, two thresholds may be used, a first and a second temperature threshold. The first temperature threshold may be the temperature threshold introduced above. For example, the second temperature threshold may be higher than the first temperature threshold. A usage of the approaches introduced above may be made dependent on the severity of the temperature of the power amplifier. In other words, depending on the temperature of the power amplifier, either the duty cycle may be adjusted by adjusting the rate of requests, or by skipping granted requests. For example, the processing circuitry may be configured to lower the duty cycle of the power amplifier by lowering a rate of requests for upstream transmission grants if the information on the temperature indicates that the temperature of the power amplifier is above the first temperature threshold (e.g. and below the second threshold). The processing circuitry may be configured to lower the duty cycle of the power amplifier by skipping one or more upstream transmissions if the information on the temperature indicates that the temperature of the power amplifier is above the second temperature threshold (and above the first temperature threshold).

After the temperature of the power amplifier has been reduced such that the temperature of the power amplifier is below the second threshold, the skipping of the upstream transmissions may be ceased. After the temperature of the power amplifier has been reduced such that the temperature of the power amplifier is below the first threshold, the rate of requests for transmission grants may be reverted to a default rate of requests for transmission grants.

The interface circuitry 12 / communication means 12 may correspond to one or more inputs and/or outputs for receiving and/or transmitting information, which may be in digital (bit) values according to a specified code, within a module, between modules or between modules of different entities. For example, the interface circuitry 12 / communication means 12 may comprise interface circuitry configured to receive and/or transmit information.

In examples, the processing circuitry 314 / processing means 314, as well as the upstream control circuitry 340 / upstream controller 340 may be implemented using one or more processing units, one or more processing devices, any means for processing, such as a processor, a computer or a programmable hardware component being operable with accordingly adapted software. In other words, the described function of the processing circuitry 314 / processing means 314, and/or the upstream control circuitry 340 / upstream controller 340, may as well be implemented in software, which is then executed on one or more programmable hardware components. Such hardware components may comprise a general-purpose processor, a Digital Signal Processor (DSP), a micro-controller, etc.

More details and aspects of the control apparatus, control device and cable modem are mentioned in connection with the proposed concept or one or more examples described above or below (e.g. Fig. 1 to 2, 4 to 7). The control apparatus, control device and cable modem may comprise one or more additional optional features corresponding to one or more aspects of the proposed concept or one or more examples described above or below.

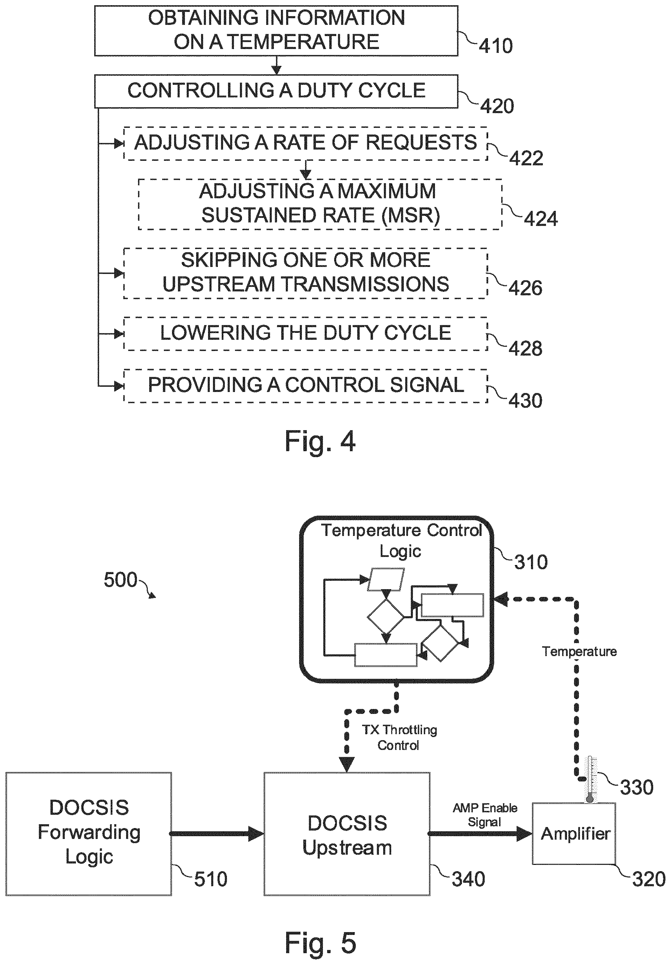

Fig. 4 shows a flow chart of an example of a corresponding method for a cable modem. The method comprises obtaining 410 information on a temperature of a power amplifier / power amplification means 320 of the cable modem from temperature measurement circuitry / means 330 of the cable modem. The method comprises controlling 420 a duty cycle of the power amplification means based on the information on the temperature.

Features described in connection with the apparatus or device of Figs. 3a to 3c may likewise be applied to the method of Fig. 4. For example, the method may optionally comprise controlling 420 the duty cycle of the power amplification means by adjusting 422 a rate of requests for upstream transmission grants of the cable modem. The method may optionally comprise adjusting 422 the rate of the requests for upstream transmission grants by adjusting 424 a maximum sustained rate for transmissions of the cable modem. The method may optionally comprise controlling 420 the duty cycle of the power amplification means by skipping 426 one or more upstream transmissions. The method may optionally comprise lowering 428 the duty cycle of the power amplification means if the information on the temperature indicates that the temperature of the power amplification means is above a temperature threshold. In effect, the method may optionally comprise lowering 428 the duty cycle of the power amplification means by lowering 424 a rate of requests for upstream transmission grants if the information on the temperature indicates that the temperature of the power amplification means is above a first temperature threshold, and lowering 428 the duty cycle of the power amplification means by skipping 426 one or more upstream transmissions if the information on the temperature indicates that the temperature of the power amplification means is above a second temperature threshold. For example, the method may optionally comprise controlling 420 the duty cycle by providing 430 a control signal to an upstream controller 340 of the cable modem, in order to trigger the upstream controller to adjust the duty cycle of the power amplification means.

Examples of the present disclosure further provide a cable modem 300 comprising a power amplification means 320 / a power amplifier 320 for amplifying a transmission signal of the cable modem, and temperature measurement means 330 for determining information on a temperature of the power amplification means, with the cable modem being configured to perform the control method of Fig. 4. Examples of the present disclosure further provide a machine-readable storage medium including program code, when executed, to cause a machine to perform the method of Fig. 4. Examples of the present disclosure further provide a computer program having a program code for performing the method of Fig. 4, when the computer program is executed on a computer, a processor, or a programmable hardware component. In more general terms, examples provide a machine-readable storage including machine readable instructions, when executed, to implement a method or realize an apparatus as shown in any example or claimed in any pending claim.

More details and aspects of the method are mentioned in connection with the proposed concept or one or more examples described above or below (e.g. Fig. 1 to 3c, 5 to 7). The method may comprise one or more additional optional features corresponding to one or more aspects of the proposed concept or one or more examples described above or below.

The approach proposed in examples may allow designing for lower heat generation from the power amplifier. This may be achieved by the CM actively limiting the duty cycle of the transmissions by monitoring transmission grants and limiting transmissions.

During the design state, the system designer may choose the components and the thermal design according to system requirements, and find the heat dissipation rate and heat generation rates of the system. The system, i.e. the cable modem, may have a temperature sensor on the PA or other measurement points that may be identified to reach marginal temperatures. The system vendor may analyze the characteristics of the temperature contribution of the PA and characterize the dependence of the temperature change vs. the transmission (for example, using a Look Up Table).

During operation, the system may operate normally while monitoring the temperature at the specified measurement points. If the system detects that the temperature levels are approaching the specified limits, it may start limiting the transmissions using the following methods. For example, transmissions may be limited by monitoring the transmission on and off times, and pausing before requesting transmission grants to achieve the overall required reduction in transmission duty cycle. Additionally or alternatively, Tx on and off times may be monitored, and transmissions may be "skipped" to reduce the transmission duty cycle and/or transmitting may be stopped all together (e.g. by skipping all grants until temperature is back within the set range). This may lead to a significant cost reduction of the DOCSIS Cable Modem platform.

Fig. 5 illustrates components involved in the approach according to various examples. Fig. 5 may show system components on the DOCSIS Gateway/cable modem 500. For example, the cable modem 500 may be implemented similar to the cable modem 300 of Figs. 3a to 3c. The gateway/modem comprises DOCSIS forwarding logic, which provides data for the DOCSIS upstream controller (i.e. upstream control circuitry) 340, which provides an amplifier enable signal to the (power) amplifier 320. Temperature measurement circuitry 330 is used to sense the temperature of the amplifier 320 (or of an environment of the amplifier), which is provided to the temperature control logic 310 (e.g. the control apparatus 310 of Figs. 3a to 3c), which provides an according TX throttling control signal for the DOCSIS upstream controller 340. The temperature sensor at the power amplifier may sense the temperature constantly and feed it to the temperature control logic 310. Based on the temperature, the control logic feeds the upstream module 340 with TX throttling controls, e.g. as described below.

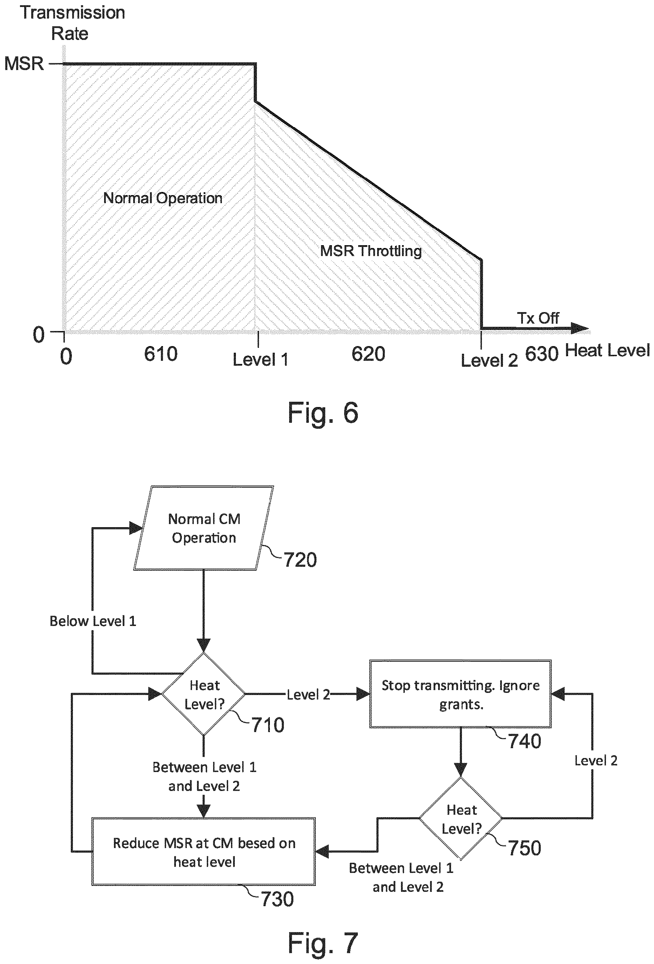

Fig. 6 shows a schematic illustration of transmission throttling being performed according to an example, i.e. a possible upstream transmission throttling scheme. For example, the target transmission duty cycle may be controlled by two mechanisms. In Fig. 3, the x-axis shows the heat level (i.e. temperature), while the y-axis shows the transmission rate (i.e. maximum sustainable rate, MSR). Three ranges 610-630 are shown, a normal operation range 610 (delimited by the threshold Level 1), an MSR throttling range 620 (delimited by threshold Level 1 and threshold Level 2), and a TX off range 630 (delimited by threshold Level 2 as lower limit).

Fig. 7 shows a schematic illustration of a transmission control algorithm/temperature control algorithm. The heat level may be determined 710. If the temperature is below Level 1, normal CM operation 720 may be maintained. When the temperature exceeds a certain level denoted by Level 1, the cable modem may take the least intrusive measures. It may attempt to throttle its transmission rate by temporarily reducing the DOCSIS maximum sustained rate (MSR), which may indirectly change the transmission duty cycle. For example, if the heat level is between level 1 and level 2, the MSR of the CM may be reduced 730 based on the heat level. Reducing MSR may cause the CM to ask the CMTS (Cable Modem Termination System) for less bandwidth, resulting in fewer grants. The level of the MSR to be set may be a function of the temperature; it may decrease as the measured temperature climbs. When temperature reaches a critical level denoted by Level 2, the cable modem may (immediately) stop transmitting 740 and ignore all grants until the temperature drops back. Thus, the heat level may be determined 750 - while the heat level is above Level 2, the cable may keep ignoring the grants 740. If the heat level is between level 1 and level 2, then the MSR may be reduced 730 based on the heat level.

More details and aspects of the proposed concept are mentioned in connection with the proposed concept or one or more examples described above or below (e.g. Fig. 1 to 4). The proposed concept may comprise one or more additional optional features corresponding to one or more aspects of the proposed concept or one or more examples described above or below.

The aspects and features mentioned and described together with one or more of the previously detailed examples and figures, may as well be combined with one or more of the other examples in order to replace a like feature of the other example or in order to additionally introduce the feature to the other example.

Example 1 relates to a control apparatus (310) for a cable modem (300), the control apparatus comprising interface circuitry (312) for communicating with one or more other components of the cable modem. The control apparatus (310) comprises processing circuitry (314) configured to obtain information on a temperature of a power amplifier (320) of the cable modem from temperature measurement circuitry (330) of the cable modem, and control a duty cycle of the power amplifier based on the information on the temperature.

In Example 2, the subject matter of example 1 or any of the Examples described herein may further include, that the processing circuitry is configured to control the duty cycle of the power amplifier by adjusting a rate of requests for upstream transmission grants of the cable modem.

In Example 3, the subject matter of example 2 or any of the Examples described herein may further include, that the processing circuitry is configured to adjust the rate of the requests for upstream transmission grants by adjusting a maximum sustained rate for transmissions of the cable modem.

In Example 4, the subject matter of one of the examples 1 to 3 or any of the Examples described herein may further include, that the processing circuitry is configured to control the duty cycle of the power amplifier by skipping one or more upstream transmissions.

In Example 5, the subject matter of one of the examples 1 to 4 or any of the Examples described herein may further include, that the processing circuitry is configured to lower the duty cycle of the power amplifier if the information on the temperature indicates that the temperature of the power amplifier is above a temperature threshold.

In Example 6, the subject matter of one of the examples 1 to 5 or any of the Examples described herein may further include, that the processing circuitry is configured to lower the duty cycle of the power amplifier by lowering a rate of requests for upstream transmission grants if the information on the temperature indicates that the temperature of the power amplifier is above a first temperature threshold, and to lower the duty cycle of the power amplifier by skipping one or more upstream transmissions if the information on the temperature indicates that the temperature of the power amplifier is above a second temperature threshold.

In Example 7, the subject matter of example 6 or any of the Examples described herein may further include, that the second temperature threshold is higher than the first temperature threshold.

In Example 8, the subject matter of one of the examples 1 to 7 or any of the Examples described herein may further include, that the processing circuitry is configured to control the duty cycle by providing a control signal to an upstream control circuitry (340) of the cable modem, in order to trigger the upstream control circuitry to adjust the duty cycle of the power amplifier.

Example 9 relates to a cable modem (300) comprising a power amplifier (320) for amplifying a transmission signal of the cable modem (300). The cable modem (300) comprises temperature measurement circuitry (330) for determining information on a temperature of the power amplifier.

In Example 10, the subject matter of example 9 or any of the Examples described herein may further include, that the temperature measurement circuitry is integrated in the power amplifier.

In Example 11, the subject matter of example 9 or any of the Examples described herein may further include, that the temperature measurement circuitry is separate from the power amplifier.

In Example 12, the subject matter of one of the examples 9 to 11 or any of the Examples described herein may further include, that the cable modem is a cable modem for communicating based on the Data Over Cable Service Interface Specification, DOCSIS.

In Example 13, the subject matter of one of the examples 1 to 8 or any of the Examples described herein may further include, that the cable modem comprises the control apparatus (310) according to one of the examples 1 to 8.

Example 14 relates to a control device (310) for a cable modem (300), the control device comprising communication means (312) for communicating with one or more other components of the cable modem. The control device (310) comprises processing means (314) configured for obtaining information on a temperature of a power amplification means (320) of the cable modem from temperature measurement means (330) of the cable modem, and controlling a duty cycle of the power amplification means based on the information on the temperature.

In Example 15, the subject matter of example 14 or any of the Examples described herein may further include, that the processing means is configured for controlling the duty cycle of the power amplification means by adjusting a rate of requests for upstream transmission grants of the cable modem.

In Example 16, the subject matter of example 15 or any of the Examples described herein may further include, that the processing means is configured for adjusting the rate of the requests for upstream transmission grants by adjusting a maximum sustained rate for transmissions of the cable modem.

In Example 17, the subject matter of one of the examples 14 to 16 or any of the Examples described herein may further include, that the processing means is configured for controlling the duty cycle of the power amplification means by skipping one or more upstream transmissions.

In Example 18, the subject matter of one of the examples 14 to 17 or any of the Examples described herein may further include, that the processing means is configured for lowering the duty cycle of the power amplification means if the information on the temperature indicates that the temperature of the power amplification means is above a temperature threshold.

In Example 19, the subject matter of one of the examples 14 to 18 or any of the Examples described herein may further include, that the processing means is configured for lowering the duty cycle of the power amplification means by lowering a rate of requests for upstream transmission grants if the information on the temperature indicates that the temperature of the power amplification means is above a first temperature threshold, and for lowering the duty cycle of the power amplification means by skipping one or more upstream transmissions if the information on the temperature indicates that the temperature of the power amplification means is above a second temperature threshold.

In Example 20, the subject matter of example 19 or any of the Examples described herein may further include, that the second temperature threshold is higher than the first temperature threshold.

In Example 21, the subject matter of one of the examples 14 to 20 or any of the Examples described herein may further include, that the processing means is configured for controlling the duty cycle by providing a control signal to an upstream controller (340) of the cable modem, in order to trigger the upstream controller to adjust the duty cycle of the power amplification means.

Example 22 relates to a cable modem (300) comprising, the cable modem comprising a power amplification means (320) for amplifying a transmission signal of the cable modem (300). The cable modem comprises temperature measurement means (330) for determining information on a temperature of the power amplification means.

In Example 23, the subject matter of example 22 or any of the Examples described herein may further include, that the temperature measurement means is integrated in the power amplification means.

In Example 24, the subject matter of example 22 or any of the Examples described herein may further include, that the temperature measurement means is separate from the power amplification means.

In Example 25, the subject matter of one of the examples 22 to 24 or any of the Examples described herein may further include, that the cable modem is a cable modem for communicating based on the Data Over Cable Service Interface Specification, DOCSIS.

In Example 26, the subject matter of one of the examples 22 to 25 or any of the Examples described herein may further include, that the cable modem comprises the control device (310) according to one of the examples 14 to 21.

Example 27 relates to a control method for a cable modem (300), the control method comprising obtaining (410) information on a temperature of a power amplification means (320) of the cable modem from temperature measurement means (330) of the cable modem. The control method comprises controlling (420) a duty cycle of the power amplification means based on the information on the temperature.

In Example 28, the subject matter of example 27 or any of the Examples described herein may further include, that the method comprises controlling (420) the duty cycle of the power amplification means by adjusting (422) a rate of requests for upstream transmission grants of the cable modem.

In Example 29, the subject matter of example 28 or any of the Examples described herein may further include, that the method comprises adjusting (422) the rate of the requests for upstream transmission grants by adjusting (424) a maximum sustained rate for transmissions of the cable modem.

In Example 30, the subject matter of one of the examples 27 to 29 or any of the Examples described herein may further include, that the method comprises controlling (420) the duty cycle of the power amplification means by skipping (426) one or more upstream transmissions.

In Example 31, the subject matter of one of the examples 27 to 30 or any of the Examples described herein may further include, that the method comprises lowering (428) the duty cycle of the power amplification means if the information on the temperature indicates that the temperature of the power amplification means is above a temperature threshold.

In Example 32, the subject matter of one of the examples 27 to 31 or any of the Examples described herein may further include, that the method comprises lowering (428) the duty cycle of the power amplification means by lowering (424) a rate of requests for upstream transmission grants if the information on the temperature indicates that the temperature of the power amplification means is above a first temperature threshold, and lowering (428) the duty cycle of the power amplification means by skipping (426) one or more upstream transmissions if the information on the temperature indicates that the temperature of the power amplification means is above a second temperature threshold.

In Example 33, the subject matter of example 32 or any of the Examples described herein may further include, that the second temperature threshold is higher than the first temperature threshold.

In Example 34, the subject matter of one of the examples 27 to 33 or any of the Examples described herein may further include, that the method comprises controlling (420) the duty cycle by providing (430) a control signal to an upstream controller (340) of the cable modem, in order to trigger the upstream controller to adjust the duty cycle of the power amplification means.

Example 35 relates to a cable modem (300). The cable modem comprises a power amplification means (320) for amplifying a transmission signal of the cable modem (300). The cable modem (300) comprises temperature measurement means (330) for determining information on a temperature of the power amplification means. The cable modem is configured to perform the control method according to one of the examples 27 to 34.

Example 36 relates to a machine-readable storage medium including program code, when executed, to cause a machine to perform the method of one of the examples 27 to 34 or according to any other example.

Example 37 relates to a computer program having a program code for performing the method of one of the examples 27 to 34 or according to any other example, when the computer program is executed on a computer, a processor, or a programmable hardware component.

Example 38 relates to a machine-readable storage including machine readable instructions, when executed, to implement a method or realize an apparatus as claimed in any pending claim or as presented in any example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a signal", "means for generating a signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software, but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A control device (310) for a cable modem (300), the control device comprising:
communication means (312) for communicating with one or more other components of the cable modem; and
processing means (314) configured for:
obtaining information on a temperature of a power amplification means (320) of the cable modem from temperature measurement means (330) of the cable modem, and controlling a duty cycle of the power amplification means based on the information on the temperature.

2. The control device according to claim 1, wherein the processing means is configured for controlling the duty cycle of the power amplification means by adjusting a rate of requests for upstream transmission grants of the cable modem.

3. The control device according to claim 2, wherein the processing means is configured for adjusting the rate of the requests for upstream transmission grants by adjusting a maximum sustained rate for transmissions of the cable modem.

4. The control device according to one of the claims 1 to 3, wherein the processing means is configured for controlling the duty cycle of the power amplification means by skipping one or more upstream transmissions.

5. The control device according to one of the claims 1 to 4, wherein the processing means is configured for lowering the duty cycle of the power amplification means if the information on the temperature indicates that the temperature of the power amplification means is above a temperature threshold.

6. The control device according to one of the claims 1 to 5, wherein the processing means is configured for lowering the duty cycle of the power amplification means by lowering a rate of requests for upstream transmission grants if the information on the temperature indicates that the temperature of the power amplification means is above a first temperature threshold, and for lowering the duty cycle of the power amplification means by skipping one or more upstream transmissions if the information on the temperature indicates that the temperature of the power amplification means is above a second temperature threshold.

7. The control device according to claim 6, wherein the second temperature threshold is higher than the first temperature threshold.

8. The control device according to one of the claims 1 to 7, wherein the processing means is configured for controlling the duty cycle by providing a control signal to an upstream controller (340) of the cable modem, in order to trigger the upstream controller to adjust the duty cycle of the power amplification means.

9. A cable modem (300) comprising:
a power amplification means (320) for amplifying a transmission signal of the cable modem (300); and
temperature measurement means (330) for determining information on a temperature of the power amplification means.

10. The cable modem according to claim 9, wherein the temperature measurement means is integrated in the power amplification means.

11. The cable modem according to claim 9, wherein the temperature measurement means is separate from the power amplification means.

12. The cable modem according to one of the claims 9 to 11, wherein the cable modem is a cable modem for communicating based on the Data Over Cable Service Interface Specification, DOCSIS.

13. The cable modem according to one of the claims 9 to 12 comprising the control device (310) according to one of the claims 1 to 8.

14. A control method for a cable modem (300), the control method comprising:
obtaining (410) information on a temperature of a power amplification means (320) of the cable modem from temperature measurement means (330) of the cable modem; and
controlling (420) a duty cycle of the power amplification means based on the information on the temperature.

15. A computer program having a program code for performing the method of claim 14, when the computer program is executed on a computer, a processor, or a programmable hardware component.
